# EUROPEAN PATENT APPLICATION

(11) **EP 2 026 082 A2**
(43) Date of publication of application: **18.02.2009**
(21) Application number: 08162268.0
(22) Date of filing: 12.08.2008
(51) Int. Cl.: G01R 33/06, G01R 15/20

(54) **Double sided integrated processing and sensing chip**

(30) Priority: 14.08.2007 US 838539
(71) Applicant: Honeywell International Inc., Morristown, NJ 07962 (US)
(72) Inventor: Wan, Hong, Plymouth, MN 55446 (US); Hughes, Grenville, Wayzata, MN 55391 (US); Keyser, Thomas, Plymouth, MN 55446 (US)
(74) Representative: Buckley, Guy Julian

(57) **Abstract**

A high density integrated processing and sensing chip includes an integrated signal processing circuit formed on one side of a substrate and a magnetic sensor element formed on an opposing side of the substrate. In one embodiment, the integrated signal processing circuit and the magnetic sensor are able to electrically connected to one another through vias or through metallic trace elements provided by a package frame.

## Description

### BACKGROUND OF THE INVENTION

Conventional integrated processing chips, also referred to as semiconductor devices, are generally manufactured with a signal processing circuit located on one side of the chip. Recently, signal processing circuits have been formed using both sides of the chip with through-wafer vias and back-side interconnections providing electronic communication from one device or circuit element to the other. Some integrated processing chips have begun to integrate fabricated sensing elements and control circuitry on a front side of a wafer. Other integrated processing chips are more segregated in that the sensing elements and the signal processing circuitry are located adjacent one another on a same side of the chip.

### SUMMARY OF THE INVENTION

The present invention provides a high density integrated processing and sensing chip having an integrated signal processing circuit on one side and a magnetic sensor element on the other side of a single chip. In one embodiment, the integrated signal processing circuit and the magnetic sensor are electrically connected to one another through vias or through metallic trace elements or through package assembly.

In one aspect of the invention, an integrated chip includes a substrate; a signal processing control circuit supportably arranged on a first side of the substrate; and a magnetic sensor element supportably positioned on an opposing side of the substrate.

In another aspect of the invention, a method for manufacturing a double-sided integrated chip includes arranging a signal processing control circuit on a first surface of the substrate; arranging a magnetic sensor element on an opposite surface of the substrate; and electrically connecting the signal processing control circuit with the magnetic sensor element.

In yet another aspect of the invention, a method for manufacturing a double-sided integrated chip includes arranging a signal processing control circuit on a first wafer; arranging a magnetic sensor element on a second wafer; and attaching the first wafer and the second wafer to a substrate, wherein the signal processing control circuit is positioned on an opposite of the substrate from the magnetic sensor element.

### BRIEF DESCRIPTION OF THE DRAWINGS

Preferred and alternative embodiments of the present invention are described in detail below with reference to the following drawings:

FIGURE 1 is a schematic, cross-sectional view of an integrated processing and sensing chip with a control circuit and a magnetic sensor located on opposite surfaces of a substrate according to an embodiment of the invention; and

FIGURE 2 is a schematic, cross-sectional view of an integrated processing and sensing chip with a control circuit and a magnetic sensor located on opposite surfaces of a substrate and with a solder bump extending from the magnetic sensor according to another embodiment of the invention; and

FIGURE 3 is a schematic view of the integrated processing and sensing chip of FIGURE 2 placed in a package frame, where the package frame provides the electrical connectivity between the control circuit and the magnetic sensor according to one illustrated embodiment of the invention.

### DETAILED DESCRIPTION OF THE PREFERRED EMBODIMENT

At least one embodiment is generally directed to an integrated processing and sensing chip that is as small as possible in terms of size and weight using known semiconductor fabrication techniques. Many magnetic sensor applications require miniature magnetic sensing elements and signal processing circuitry integrated on a single substrate. The substrate may be silicon or an equivalent semiconductor material such as gallium arsenide, Germanium or Indium Phosphide, *etc*.

In a preferred embodiment, the integrated processing and sensing chip is a high density, multi-functional chip with a silicon substrate structure that supports a magnetic sensor element on one side of the substrate and control circuitry on an opposing side of the substrate. Forming the chip with the magnetic sensor element and the control circuitry on opposing sides of the substrate advantageously reduces the overall size of the chip while managing to increase the chip's overall functionality. By way of example, applicants have found during the development of the invention that locating the control circuitry on one side of the substrate and the magnetic sensor element on the other side may reduce the overall size of the chip by about fifty percent (50%). In addition, forming connections to both sides of the chip may also help reduce the overall size of the chip. The integrated processing and sensing chip simplifies the integration of both processing and sensing functions, provides greater flexibility during fabrication of the chip because the front and back sides of the chip may be fabricated in different parts of a facility or even in different facilities. Consequently, the integrated processing and sensing chip may provide manufacturing, functionality, size, weight, and economic advantages

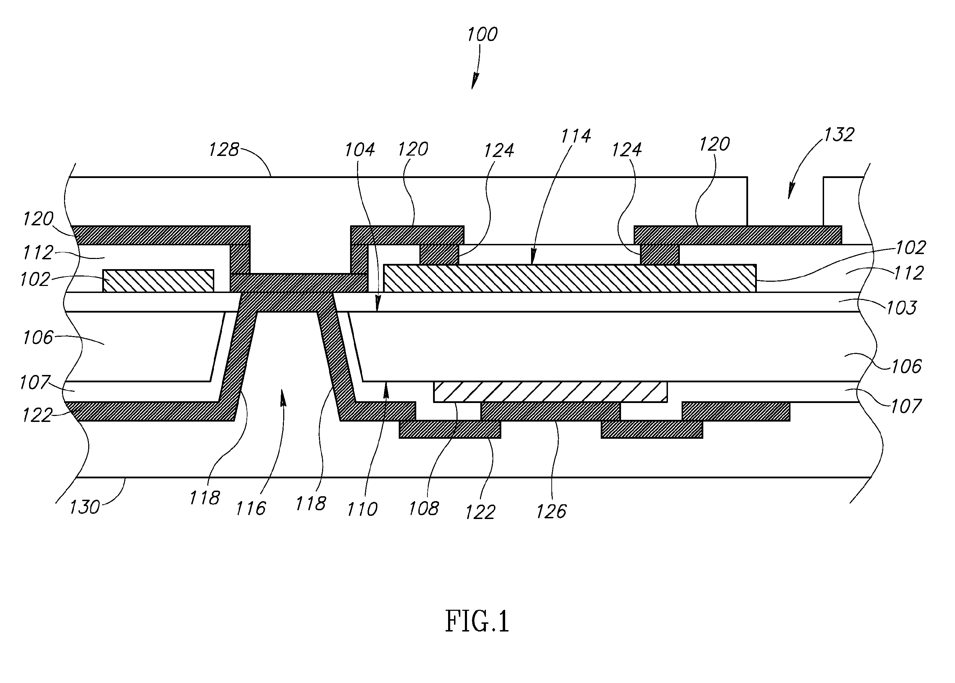

FIGURE 1 shows a schematic cross-sectional view of an integrated processing and sensing wafer 100 having a signal processing circuit or signal processing layer 102 located proximate a first surface 104 of a substrate layer 106 and a magnetic sensing element 108 located on an opposite surface 110 of the substrate layer 106 according to one embodiment of the invention. In one embodiment, the signal processing circuit 102 and the magnetic sensing element 108 are electrically connected to with one another through metal layers (122) and vias (116).

In the illustrated embodiment, the signal processing circuit 102 is positioned on a first optional layer 103, which may be a silicon layer located adjacent the first surface 104 of the substrate layer 106. In addition, a dielectric layer 112, which may be made of Silicon Dioxide, helps protect the signal processing circuit 102 and is located at least partially on an exterior surface 114 of the signal processing circuit 102. The magnet sensor element 108, on the other hand, abuts the opposite surface 110 of the substrate layer 106. Layer 107 is another dielectric layer, which may be made from silicon dioxide and helps protect the magnetic sensor element 108. Layer 107 is located adjacent the opposite surface 110 of the substrate layer 106.

In one embodiment, vias 116 are formed through the substrate layer 106. Metal trace elements 118, such as an aluminum alloy or other conductive element, are provided adjacent the vias 116 to provide an electronic communication path between a circuit interconnection layer 120 and a sensor interconnection layer 122. The circuit interconnection layer 120 may be coupled to the trace elements 118 using an intermediate a circuit connection element 124 that extends through the circuit protection layer 112. The sensor interconnection layer 122 is arranged such that a majority of the sensor interconnection layer 122 abuts the dielectric layer 107 while another portion 126 is in direct contact with the magnetic sensor element 108.

The integrated processing and sensing wafer 100 further includes a first scratch protection layer 128 located on the circuit interconnection layer 120 and a second scratch protection layer 130 located on the sensor interconnection layer 122. The scratch protection layer may be silicon nitride or other similar, scratch resistant material. In addition, openings 132 are etched in at least the first scratch protection layer 128 for wire bond or solder bump connections and it is appreciated that similar opening may be etched or formed in the second scratch protection layer 130.

By way of example, there are several techniques of forming the wafer 100. In one embodiment, the signal processing circuit 102 and the magnetic sensor element 108 are fabricated separately and then later combined to complete the wafer 100. By way of example, the signal processing circuit 102 may be fabricated as a first layer and the magnetic sensor element 108, which may include one or more miniature magnetic sensor elements, may be fabricated as a second layer. The assembly comprised of layers 102 with 103 and 107 with 108 may be bonded to the substrate layer 106 using an adhesive or a spin-on glass layer, for example. With this technique, electrical connections between the signal processing circuit 102 and the magnetic sensor element 108 may be provided using wire bond or solder bump connections coupled to an externally conductive frame (not shown).

In another embodiment, the signal processing circuit 102 and the magnetic sensor element 108 are fabricated as a single unit. In this embodiment, the electrical connections between the signal processing circuit 102 and the magnetic sensor element 108 may provided the vias 116 and metal trace elements 118 as described above.

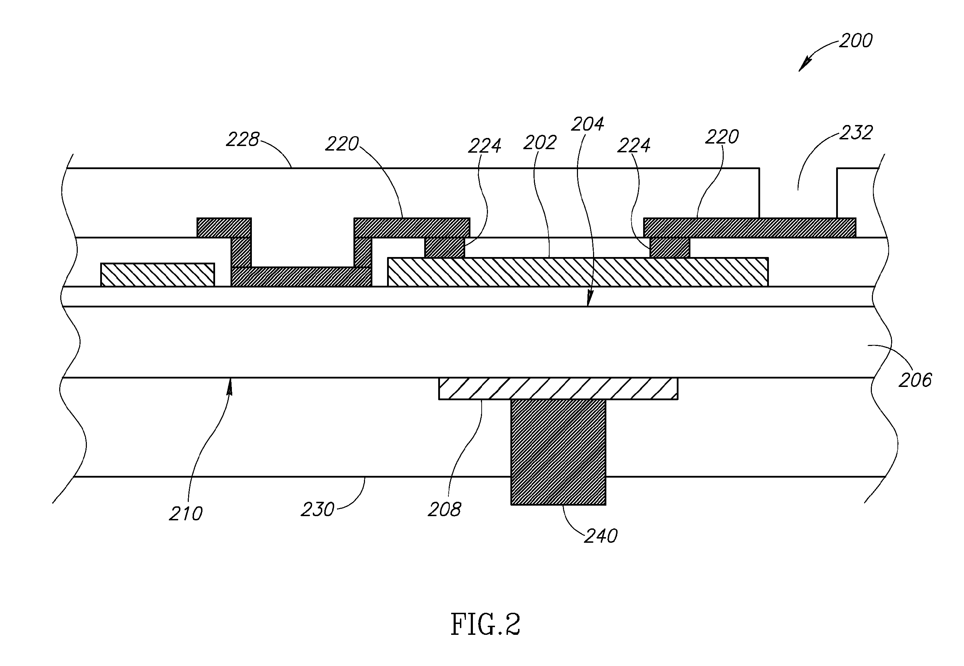

FIGURE 2 shows a schematic cross-sectional view of an integrated processing and sensing wafer 200 having a signal processing circuit or signal processing layer 202 located proximate a first surface 204 of a substrate layer 206 and a magnetic sensing element or magnetic sensing layer 208 located on an opposite surface 210 of the substrate layer 206 according to another embodiment of the invention. A circuit interconnection layer 220 is located on a first intermediate layer 212 and may include metal-filled vias 224 for making an electrical connection with the signal processing circuit 202. In addition, a first scratch protection layer 228 is located on the circuit interconnection layer 220. A second scratch protection layer 230 is located over the magnetic sensor element 208 and adjacent to the substrate layer 206. Openings 232 are provided in at least the first scratch protection layer 228 for wire connections as described below.

The primary difference between the present embodiment 200 and the above-described embodiment 100 is that the present embodiment 200 does not include any vias 116 (FIGURE 1). Instead, a sensor interconnection bump 240 extends from direct contact with the magnetic sensor element 208 through the second scratch protection layer 230. By way of example, electrical connection between the sensor element 108 and the signal processing layer 202 may be achieved using a sensor interconnect system to route wires to various bump positions and connection elements.

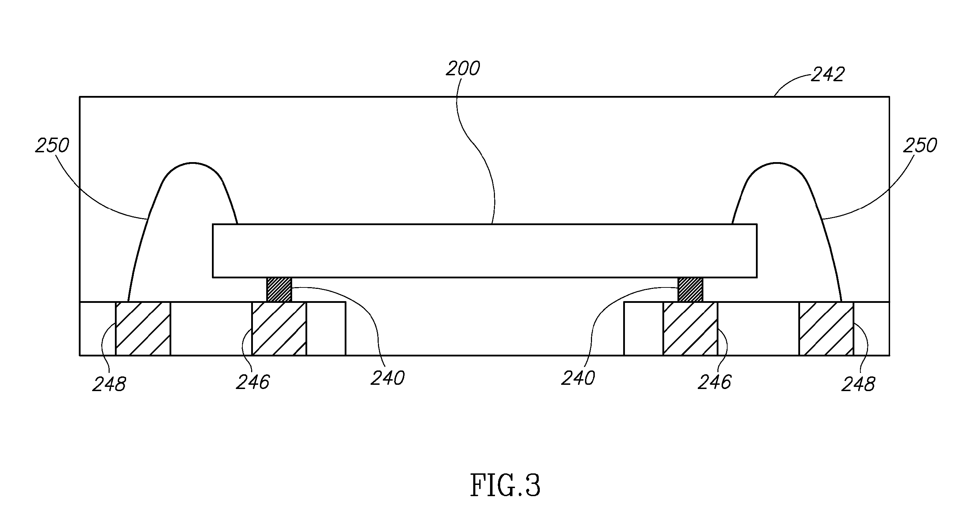

FIGURE 3 shows that the electrical connectivity between the circuit layer 220 and the sensor interconnection bump 240 is provided by attaching the integrated processing and sensing wafer 200 in a package 242. The package 242 includes package conductors or metal traces 246, 248 for establishing an electrical connection between the signal processing layer 202 (FIGURE 2) and the magnetic sensor element 208 (FIGURE 2). A wire 250 completes the electrical connection by providing an electrical conductivity path between the package conductor 248 and the circuit interconnection layer 220 (FIGURE 2). The wire 250 is bonded to the circuit interconnection layer 220 (FIGURE 2) and extends from the openings 232 (FIGURE 2) etched in the first scratch protection layer 228 (FIGURE 2).

The magnetic sensor elements 108, 208 may be formed using known technologies, such as Hall, anisotropic magnetoresistance (AMR), giant magnetoresistance (GMR), and giant magneto-impedance (GMI), all of which are thin film technologies that are generally compatible with integrated circuit fabrication.

While the preferred embodiment of the invention has been illustrated and described, as noted above, many changes can be made without departing from the spirit and scope of the invention. Accordingly, the scope of the invention is not limited by the disclosure of the preferred embodiment. Instead, the invention should be determined entirely by reference to the claims that follow.
The embodiments of the invention in which an exclusive property or privilege is claimed are defined as follows:

## Claims

1. An integrated chip comprising:
a substrate;
a signal processing control circuit supportably arranged on a first side of the substrate; and
a magnetic sensor element supportably positioned on an opposing side of the substrate.

2. The integrated chip of Claim 1, further comprising a plurality of vias connecting the signal processing control circuit to the magnetic sensor element.

3. The integrated chip of Claim 1, further comprising a frame coupled to the integrated chip, wherein the frame includes metal traces for electrically connecting the signal processing control circuit with the magnetic sensor element.

4. The integrated chip of Claim 1, further comprising a plurality of metal conductive paths for electrically interconnecting the signal processing control circuit with the magnetic sensor element.

5. The integrated chip of Claim 1, further comprising a scratch protection layer located on a circuit interconnection layer and having etched openings therein for receiving an electrically conductive element.

6. A method for manufacturing a double-sided integrated chip, the method comprising:
arranging a signal processing control circuit on a first surface of the substrate;
arranging a magnetic sensor element on an opposite surface of the substrate; and
electrically connecting the signal processing control circuit with the magnetic sensor element.

7. The method of Claim 6, further comprising forming a scratch protection layer over a circuit interconnection layer coupled to and located on the signal processing control circuit.

8. The method of Claim 6, wherein electrically connecting the signal processing control circuit with the magnetic sensor element includes forming vias that extend through the substrate.

9. The method of Claim 6, wherein electrically connecting the signal processing control circuit with the magnetic sensor element includes connecting a circuit interconnection layer in contact with the signal processing control circuit with a sensor interconnection layer in contact with the magnetic sensor element.

10. A method for manufacturing a double-sided integrated chip, the method comprising:
arranging a signal processing control circuit on a first wafer;
arranging a magnetic sensor element on a second wafer; and
attaching the first wafer and the second wafer to a substrate, wherein the signal processing control circuit is positioned on an opposite of the substrate from the magnetic sensor element.
